# EUROPÄISCHE PATENTSCHRIFT

(11) **EP 3 979 270 B1**
(45) Veröffentlichungstag und Bekanntmachung des Hinweises auf die Patenterteilung: **29.01.2025**
(21) Anmeldenummer: 21195478.9
(22) Anmeldetag: 08.09.2021
(51) Int. Cl.: H01F 5/06, H01F 27/30, H03K 17/95

(54) **INDUKTIVE SENSOREINRICHTUNG**
INDUCTIVE SENSOR DEVICE
DISPOSITIF CAPTEUR INDUCTIF

(30) Priorität: 29.09.2020 DE 102020212238
(43) Veröffentlichungstag der Anmeldung: 06.04.2022
(73) Patentinhaber: Pepperl+Fuchs SE, 68307 Mannheim (DE)
(72) Erfinder: ELTER, Johann, 12277 Berlin (DE); DREBES, Patrick, 12277 Berlin (DE)
(74) Vertreter: Fischer, Uwe

(56) Entgegenhaltungen:
- DE-B3- 102010 064 607
- DE-T2- 69 828 437
- DE-U- 7 137 735
- DE-U1- 8 438 084
- US-A1- 2018 266 851

## Beschreibung

Die Erfindung bezieht sich auf ein Verfahren zum Herstellen einer induktiven Sensoreinrichtung, wobei bei dem Verfahren eine Spule in einen Schalenkern eingesetzt wird.

Ein Verfahren zum Herstellen einer induktiven Sensoreinrichtung ist beispielsweise aus der deutschen Patentschrift DE 10 2010 064 607 B3 bekannt. Bei dem vorbekannten Verfahren wird ein Draht unter Bildung einer Spule auf einem Spulenkörper aufgewickelt, der im Rahmen der Montage nachfolgend in einen Schalenkern der Sensoreinrichtung eingeführt wird. Der Spulenkörper ist mit Führungsnuten zum Einlegen der elektrischen Anschlüsse der Spule ausgestattet; die Führungsnuten ermöglichen eine Verbindung der elektrischen Anschlüsse der Spule mit an den Spulenkörper angebrachten elektrischen Kontaktstiften. Die Kontaktstifte werden durch Durchgangslöcher im Schalenkern zum Zwecke eines Anschlusses an eine Leiterplatte hindurchgeführt.

Ein Verfahren mit den Merkmalen des Oberbegriffs des Patentanspruchs 1 ist aus der deutschen Gebrauchsmusterschrift DE 71 37 735 U bekannt.

Der Erfindung liegt die Aufgabe zugrunde, ein Verfahren zum Herstellen einer induktiven Sensoreinrichtung anzugeben, das besonders einfach und kostengünstig durchführbar ist.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass als Spule eine selbsttragende, spulenkörperfreie Spule in eine umlaufende Nut des Schalenkerns eingesetzt wird.

Ein wesentlicher Vorteil des erfindungsgemäßen Verfahrens besteht darin, dass durch das Einsetzen einer selbsttragenden, spulenkörperfreien Spule in eine umlaufende Nut des Schalenkerns auf das zusätzliche Vorsehen eines Spulenkörpers, wie er bei der eingangs genannten Patentschrift notwendig ist, verzichtet werden kann. Abgesehen von der Materialersparnis werden zusätzliche Herstellungs- und Montageschritte eingespart.

Biegesteife Anschlüsse vereinfachen in vorteilhafter Weise das Anschließen der Anschlüsse an andere elektrische Komponenten, wie beispielsweise eine Leiterplatte, ohne zusätzliche weitere Zwischenelemente, beispielsweise ohne Zwischenelemente wie die eingangs erwähnten Führungsnuten oder Kontaktstifte.

Mit Blick auf eine elektrische Anbindung der Spule ist erfindungsgemäß vorgesehen, dass die elektrischen Anschlüsse der Spule unmittelbar mit einer Auswertschaltung der Sensoreinrichtung elektrisch verbunden, insbesondere unmittelbar mit Anschlussflächen auf einer Leiterplatte der Auswertschaltung verlötet werden. Durch das direkte Anbringen der biegestabilen Anschlüsse auf einer Leiterplatte - ohne Zwischenelemente - wird eine hohe mechanische Flexibilität zwischen dem Schalenkern und der Spule einerseits und der Leiterplatte andererseits gewährleistet, sodass Kraftspitzen, die von außen auf die spätere Sensoreinrichtung einwirken, abgemildert werden können.

Mit Blick auf eine einfache Montage wird es als vorteilhaft angesehen, wenn die Anschlüsse jeweils vom Wickelbereich der Spule bis zu den zugehörigen Anschlussenden versteift werden, sich also die biegesteifen Anschlüsse jeweils vom Wickelbereich der Spule bis zu den zugehörigen Anschlussenden erstrecken.

Alternativ ist es möglich, wenn auch weniger vorteilhaft, die elektrischen Anschlüsse der Spule mit Anschlusselementen des Schalenkerns, die vorzugsweise an dem Schalenkern angebracht oder einstückig an dem Schalenkern angeformt sind, zu verbinden und wiederum die Anschlusselemente des Schalenkerns mit der Auswertschaltung der Sensoreinrichtung elektrisch zu verbinden.

Die elektrischen Anschlüsse der Spule werden vorzugsweise durch Beschichten, Verkleben und/oder durch Verzinnen mechanisch versteift.

Um Kurzschlüsse zu vermeiden, erfolgt das Versteifen vorzugsweise zumindest in denjenigen Bereichen, die mit dem Schalenkern Kontakt haben oder haben könnten, vorzugsweise mit einem nichtleitenden Material, wie beispielsweise Kunststoff oder einem nichtleitenden Kleber.

Die Anschlussenden der Anschlüsse werden vorzugsweise durch Aufbringen von leitfähigem Material, beispielsweise durch Verzinnen, versteift, insbesondere um ein späteres Auflöten der Anschlussenden auf einer Leiterplatte zu vereinfachen.

Mit Blick auf eine mechanische Führung der Anschlüsse der Spule wird es als vorteilhaft angesehen, wenn der Schalenkern zumindest einen randseitigen Schlitz und/oder ein Durchgangsloch aufweist und mindestens einer der elektrischen Anschlüsse abschnittsweise in den randseitigen Schlitz eingelegt oder durch das Durchgangsloch hindurchgeführt wird.

Mit Blick auf eine einfache Vorjustierung der biegesteifen Anschlüsse wird es als vorteilhaft angesehen, wenn der Schalenkern einen ersten randseitigen Schlitz und einen zweiten randseitigen Schlitz aufweist, ein Abschnitt eines der elektrischen Anschlüsse der Spule in den ersten randseitigen Schlitz eingelegt wird und durch diesen außen an dem Schalenkern vorbeigeführt wird und ein Abschnitt des anderen elektrischen Anschlusses der Spule in den zweiten randseitigen Schlitz eingelegt wird und durch diesen außen an dem Schalenkern vorbeigeführt wird.

Die selbsttragende, spulenkörperfreie Spule wird vorzugsweise hergestellt, indem während und/oder nach dem Wickeln der Spule die Wicklungen untereinander verklebt werden.

Als besonders vorteilhaft wird es angesehen, wenn die selbsttragende, spulenkörperfreie Spule durch Wickeln eines Drahts, der eine temperaturfeste Grundisolation und eine bei Erhitzen selbst verklebende Deckschicht aufweist, hergestellt wird und während und/oder nach dem Wickeln der Spule die Spule erhitzt und/oder mit einem Lösungsmittel behandelt wird und dadurch die Wicklungen der Spule untereinander mit dem Material der Deckschicht verklebt werden.

Die selbsttragende, spulenkörperfreie Spule wird vorzugsweise aus einem sogenannten Backlackdraht hergestellt.

Vorteilhaft ist es, wenn der Schalenkern aus einem magnetisierbaren Material besteht oder magnetisierbares Material aufweist.

Besonders vorteilhaft ist es, wenn der Schalenkern aus einem Ferrit besteht oder ein Ferrit aufweist.

Die selbsttragende, spulenkörperfreie Spule wird vorzugsweise zwischenkörperfrei in die umlaufende Nut des Schalenkerns eingesetzt.

Die Erfindung bezieht sich darüber hinaus auf eine induktive Sensoreinrichtung mit einem Schalenkern und einer Spule. Erfindungsgemäß ist vorgesehen, dass die Spule so hergestellt wurde, wie es oben beschrieben wurde.

Bezüglich der Vorteile und vorteilhafter Ausgestaltungen der erfindungsgemäßen Sensoreinrichtung sei auf die obigen Ausführungen im Zusammenhang mit dem erfindungsgemäßen Verfahren und dessen vorteilhafter Ausgestaltungen verwiesen.

Vorteilhaft ist es, wenn die biegesteifen Anschlüsse jeweils vom Wickelbereich der Spule bis zu den zugehörigen Anschlussenden versteift sind.

Die biegesteifen Anschlüsse der Spule sind vorzugsweise unmittelbar mit einer Auswertschaltung der Sensoreinrichtung elektrisch verbunden, insbesondere mit Anschlussflächen auf einer Leiterplatte der Anschlussschaltung verlötet.

Die Erfindung wird nachfolgend anhand von Ausführungsbeispielen näher erläutert; dabei zeigen beispielhaft
- Fig. 1-2: dreidimensionale Darstellungen eines Ausführungsbeispiels für ein Schalenelement mit einer darin eingelegten selbsttragenden, spulenkörperfreien Spule,
- Fig. 3: eine dreidimensionale Darstellung eines Ausführungsbeispiels für eine Leiterplatte mit Vorsprung,
- Fig. 4: die Leiterplatte gemäß Figur 3 nach einem Einstecken des Vorsprungs in das Schalenelement gemäß den Figuren 1 und 2,
- Fig. 5: die Anordnung gemäß Figur 4 im Querschnitt, und
- Fig. 6: ein Ausführungsbeispiel für eine Leiterplatte mit geschlitztem Vorsprung, beispielsweise zur Ausbildung einer Schnapphakenverbindung mit dem Schalenelement.

In den Figuren werden für identische oder vergleichbare Komponenten stets dieselben Bezugszeichen verwendet.

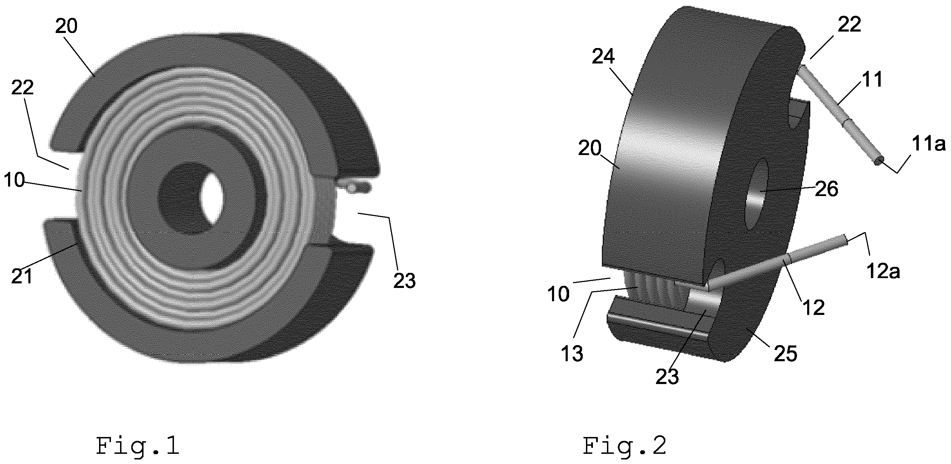

Die Figur 1 zeigt in einer dreidimensionalen Darstellung schräg von der Seite ein Ausführungsbeispiel für eine Spule 10, die in eine umlaufende Nut 21 eines Schalenkernes 20 eingesetzt ist. Bei der Spule 10 handelt es sich um eine selbsttragende, spulenkörperfreie Spule, die vorzugsweise ohne jeglichen Zwischenkörper in die umlaufende Nut 21 eingesetzt ist. Zur Fixierung der Spule 10 in der umlaufenden Nut 21 kann Klebstoff vorgesehen werden, jedoch ist dieser nicht zwingend erforderlich.

Die Spule 10 wird vorzugsweise hergestellt, indem während und/oder nach dem Wickeln der Spule die Wicklungen untereinander verklebt werden, sei es durch Aufbringen eines externen Klebstoffes oder durch Heißkleben bzw. "Verbacken" von Mantelmaterial des aufgewickelten Spulendrahtes.

Vorteilhaft ist es beispielsweise, wenn die Spule 10 durch Wickeln eines Drahtes, der eine temperaturfeste Grundisolation und eine bei Erhitzen selbst verklebende Deckschicht aufweist, hergestellt wird. Bei dem Draht kann es sich beispielsweise um einen sogenannten Backlackdraht handeln. Zum Verkleben der Drahtspule kann während und/oder nach dem Wickeln die Spule 10 erhitzt und/oder mit einem Lösungsmittel behandelt werden, wodurch die Deckschicht die Wicklungen der Spule miteinander verklebt.

Die Figur 2 zeigt den Schalenkern 20 mit der darin eingesetzten Spule 10 in einer anderen dreidimensionalen Darstellung. Die Spule 10 ist bei der Darstellung gemäß Figur 2 von der in der Figur 2 linken Seite 24 in die umlaufende Nut 21 des Schalenkernes 20 eingesetzt.

Es lässt sich in der Figur 2 außerdem erkennen, dass die zwei elektrischen Anschlüsse 11 und 12 der Spule 10 biegesteif ausgeführt sind, also selbst formstabil sind. Besonders vorteilhaft ist es, wenn sich die biegesteifen Bereiche der elektrischen Anschlüsse 11 und 12 jeweils durchgängig vom Wickelbereich 13 der Spule 10 bis zum Anschlussende 11a und 12a des jeweiligen Anschlusses 11 bzw. 12 erstrecken, also mit anderen Worten die Anschlüsse 11 und 12 jeweils ab dem Wickelbereich 13 versteift sind.

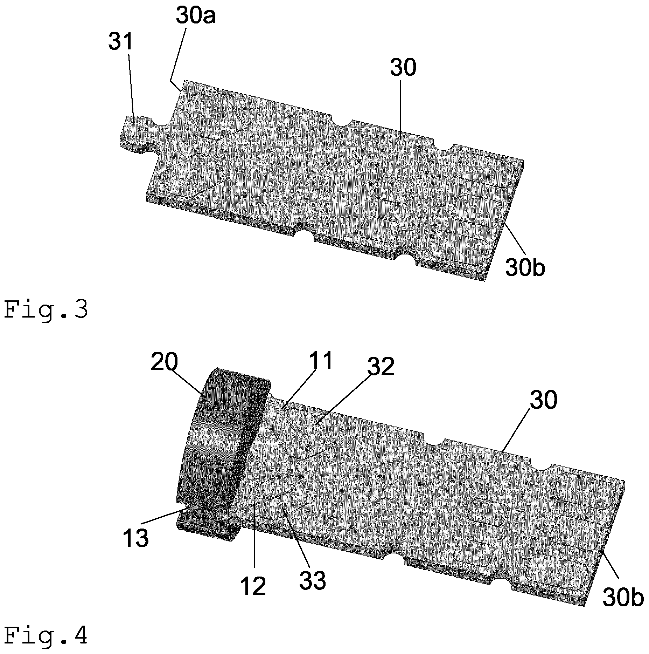

Das Versteifen der elektrischen Anschlüsse 11 und 12 erfolgt vorzugsweise durch Aufbringen von elektrisch nichtleitendem Material, wie beispielsweise nichtleitendem Klebstoff, zumindest in dem Bereich, der mit dem Schalenkern 20 in Kontakt steht; die Anschlussenden 11a und 12a selbst werden vorzugsweise durch Aufbringen von leitfähigem Material, beispielsweise durch Verzinnen versteift, um das spätere Auflöten der Anschlussenden 11a und 12a auf einer Leiterplatte 30 (siehe Figur 4) zu vereinfachen.

Bei dem Ausführungsbeispiel gemäß Figur 2 sind die elektrischen Anschlüsse 11 und 12 abschnittsweise jeweils in einen zugeordneten randseitigen Schlitz 22 bzw. 23 des Schalenkerns 20 eingelegt und werden mittels dieser Schlitze 22 und 23 von der umlaufende Nut 21 aus zu der in der Figur 2 rechten Seite 25 des Schalenkerns 20 geführt.

Die in der Figur 2 gezeigte Führung der biegesteifen Anschlüsse 11 und 12 mittels zweier Schlitze 22 und 23 wird als sehr vorteilhaft angesehen; alternativ kann auch ein einziger Schlitz zur Führung beider elektrischer Anschlüsse 11 und 12 vorgesehen werden. Auch kann alternativ vorgesehen sein, im Schalenkern 20 ein oder zwei in der Figur 2 nicht gezeigte Löcher vorzusehen, die sich von der umlaufende Nut 21 zu der in der Figur 2 rechten Seite 25 des Schalenkerns 20 erstrecken und ein Hindurchführen der biegesteifen Anschlüsse 11 und 12 erlauben.

Bei dem Ausführungsbeispiel sind die biegesteifen Anschlüsse 11 und 12 gemäß Figur 2 in den Schlitzen 22 und 23 randseitig außen an dem Schalenkern 20 vorbeigeführt und sind dadurch räumlich voneinander getrennt. Vorteilhaft ist es, wenn die Anordnung der Schlitze 22 und 23 zu der Anordnung von Anschlussflächen (siehe Figur 4) auf einer Leiterplatte korrespondiert, damit die Anschlüsse 11 und 12 ohne weiteren Biegeaufwand mit einer Auswertschaltung verbunden werden können; dies wird weiter unten im Zusammenhang mit der Figur 4 noch näher erläutert.

Die Figur 3 zeigt in einer dreidimensionalen Darstellung ein Ausführungsbeispiel für eine Leiterplatte 30, die zum Tragen von elektrischen und/oder elektronischen Bauelementen geeignet ist. Die elektrischen und/oder elektronischen Bauelemente sind aus Gründen der Übersicht in der Figur 3 nicht näher dargestellt und bilden gemeinsam mit der Leiterplatte eine Auswertschaltung, die mit den biegesteifen Anschlüssen 11 und 12 der Spule 10 gemäß den Figuren 1 und 2 verbunden wird.

Die Spule 10 allein oder die Spule 10 in Kombination mit der Auswertschaltung bildet elektrisch vorzugsweise einen elektrischen Oszillator, dessen Resonanzfrequenz bzw. Oszillationsfrequenz vom magnetischen Feld im Bereich der Spule 10 abhängt. Nähert sich beispielsweise ein Objekt der Spule 10 bzw. dem Schalenkern 20, so wird der Oszillator verstimmt, was die Auswertschaltung anhand eines sich verändernden elektrischen Spulensignals feststellen wird; diese Änderung kann die Auswertschaltung zur Bildung eines entsprechenden Detektionssignals heranziehen. Die Möglichkeiten zur Auswertung von elektrischen Spulensignalen bei induktiven Sensoreinrichtungen zum Zwecke der Detektion einer Objektannäherung sind allgemein bekannt, sodass hier auf den einschlägigen Stand der Technik, beispielsweise auch auf die eingangs genannte Patentschrift DE 10 2010 064 607 B3 und die darin genannten Druckschriften verwiesen werden kann.

Die Figur 3 zeigt darüber hinaus einen Vorsprung 31, der an dem in der Figur 3 linken Leiterplattenende 30a der Leiterplatte 30 angeordnet ist. Der Vorsprung 31 dient zur Justage und Fixierung der Leiterplatte 30 an dem Schalenkern 20; zu diesem Zweck wird der Vorsprung 31 der Leiterplatte 30 vorzugsweise in ein Durchgangsloch 26 (siehe Figuren 1 und 2) oder eine entsprechende Vertiefung im Schalenkern 20 eingeführt.

Die Figur 4 zeigt beispielhaft die Leiterplatte 30, nachdem diese mit dem Schalenkern 20 gemäß den Figuren 1 und 2 mechanisch verbunden wurde. Man erkennt, dass der Vorsprung 31 in das Durchgangsloch 26 im Schalenkern 20 eingesteckt worden ist.

Es lässt sich außerdem erkennen, dass sich - aufgrund der biegesteifen Ausführung der elektrischen Anschlüsse 11 und 12 und aufgrund der Position der Schlitze 22 und 23 - die elektrischen Anschlüsse 11 und 12 bei dem Ausführungsbeispiel gemäß Figur 4 automatisch bzw. selbsttätig auf elektrischen Anschlussflächen 32 und 33 der Leiterplatte 30 positionieren, sobald der Vorsprung 31 in das Durchgangsloch 26 im Schalenkern 20 eingesteckt wird; eine manuelle Nachjustage ist somit in vorteilhafter Weise in der Regel nicht mehr erforderlich.

Nach dem Einschieben der Leiterplatte 30 können die auf den elektrischen Anschlussflächen 32 und 33 bereits vorpositionierten elektrischen Anschlüsse 11 und 12 also meist ohne weitere Justage beispielsweise angelötet werden.

Durch das direkte Anbringen der formstabilen Anschlüsse 11 und 12 auf der Leiterplatte 30 ohne Zwischenelemente wird außerdem eine gewisse mechanische Flexibilität zwischen dem Schalenkern 20 und der Spule 10 einerseits und der Leiterplatte 30 andererseits gewährleistet, sodass Kraftspitzen bei äußerer Belastung abgemildert werden.

Die auf der Leiterplatte 30 angeordnete, in den Figuren nicht gezeigte Auswertschaltung ist vorzugsweise an dem in Figur 4 rechten Leiterplattenende 30b, also an dem von dem Vorsprung 31 entfernten Leiterplattenende, mit nicht gezeigten Anschlusskontakten verbunden. Die Anschlusskontakte ermöglichen einen Anschluss der Leiterplatte 30 und der Auswertschaltung an externe Einrichtungen oder Geräte.

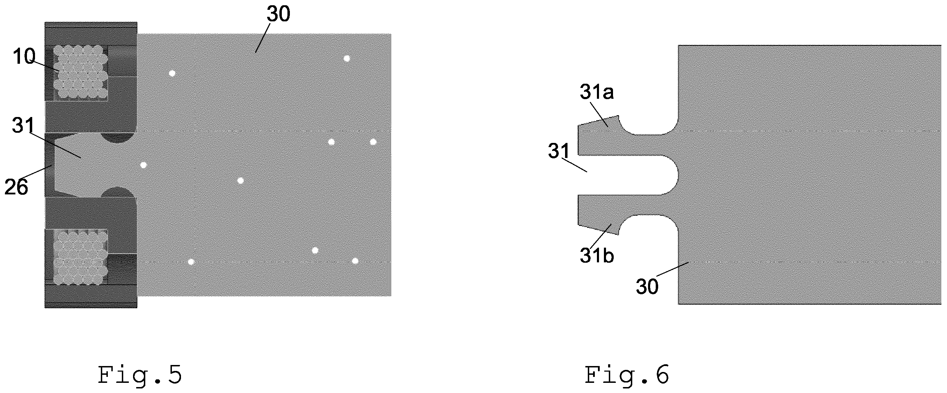

Die Figur 5 zeigt die resultierende Anordnung gemäß Figur 4 in einem Querschnitt. Es lässt sich erkennen, dass der Vorsprung 31 der Leiterplatte 30 im Durchgangsloch 26 vorzugsweise verklemmt ist, sodass nicht nur eine Justage bzw. Ausrichtung der Leiterplatte 30 relativ zum Schalenkern 20 erreicht wird, sondern auch eine gewisse mechanische Fixierung.

Beispielsweise kann zur Fixierung der Leiterplatte 30 vorgesehen werden, dass der Vorsprung 31 ein gewisses Übermaß bezüglich des Durchmessers des Durchgangslochs 26 aufweist, sodass bei einem Einpressen des Vorsprungs 31 ein Abschaben von Leiterplattenmaterial auftritt und eine feste reibschlüssige Verbindung zwischen den beiden Teilen 20 und 30 hergestellt wird.

Die Figur 6 zeigt ein weiteres Ausführungsbeispiel für eine mögliche Ausgestaltung der Leiterplatte 30. Es lässt sich erkennen, dass der Vorsprung 31 in der Figur 6 geschlitzt ausgeführt ist und zwei Hakenabschnitte 31a und 31b bildet. Die Hakenabschnitte ermöglichen ein gewisses Auslenken in radialer Richtung, sodass sich diese federnd an die Innenseite des Durchgangslochs 26 im Schalenkern 20 anlegen können.

Die Ausgestaltung der Hakenabschnitte 31a und 31b kann in vorteilhafter Weise derart gewählt werden, dass diese Rasthaken bilden, die gemeinsam mit dem Durchgangsloch 26 des Schalenkerns 20 eine Schnappverbindung bilden, durch die die Leiterplatte 30 mit dem Schalenkern 20 formschlüssig verschnappt werden kann, damit diese eine gemeinsame, mechanisch feste Baugruppe bilden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.

### Bezugszeichenliste

- 10: Spule
- 11: elektrischer Anschluss
- 11a: Anschlussende
- 12: elektrischer Anschluss
- 12a: Anschlussende
- 13: Wickelbereich
- 20: Schalenkern
- 21: Nut
- 22: Schlitz
- 23: Schlitz
- 24: linke Seite
- 25: rechte Seite
- 26: Durchgangsloch
- 30: Leiterplatte
- 30a: linkes Leiterplattenende
- 30b: rechtes Leiterplattenende
- 31: Vorsprung
- 31a: Hakenabschnitt
- 31b: Hakenabschnitt
- 32: elektrische Anschlussfläche
- 33: elektrische Anschlussfläche

## Patentansprüche

1. Verfahren zum Herstellen einer induktiven Sensoreinrichtung, wobei bei dem Verfahren eine Spule (10) in einen Schalenkern (20) eingesetzt wird, wobei als Spule (10) eine selbsttragende, spulenkörperfreie Spule (10) in eine umlaufende Nut (21) des Schalenkerns (20) eingesetzt wird, wobei:
- der Schalenkern (20) eine Vertiefung oder ein Durchgangsloch (26) aufweist,
- die elektrischen Anschlüsse (11, 12) der Spule (10) unmittelbar mit einer Auswertschaltung der Sensoreinrichtung elektrisch verbunden sind, **dadurch gekennzeichnet, dass**:
- in die Vertiefung oder das Durchgangsloch des Schalenkerns ein Vorsprung einer Leiterplatte mit der Auswerteschaltung der Sonsoreinrichtung eingeschoben wird,
- die elektrischen Anschlüsse der Spule unmittelbar mit Anschlussflächen (32, 33) auf der Leiterplatte (30) der Auswertschaltung verlötet werden, indem nach dem Einschieben der Leiterplatte (30) die auf den elektrischen Anschlussflächen (32, 33) bereits vorpositionierten elektrischen Anschlüsse (11, 12) angelötet werden,
- wobei Anschlussenden (11a, 12a) der elektrischen Anschlüsse (11, 12) vor oder nach dem Einsetzen der Spule (10) in den Schalenkern (20) mechanisch versteift werden und biegesteife Anschlüsse (11, 12) gebildet werden, und zwar vor dem Auflöten der Anschlussenden (11a, 12a) auf der Leiterplatte (30), um das spätere Auflöten der Anschlussenden auf der Leiterplatte (30) zu vereinfachen.

2. Verfahren nach Anspruch 1,
**dadurch gekennzeichnet, dass**
die elektrischen Anschlüsse (11, 12) jeweils vom Wickelbereich (13) der Spule (10) bis zu den zugehörigen Anschlussenden (11a, 12a) versteift werden.

3. Verfahren nach einem der voranstehenden Ansprüche, **dadurch gekennzeichnet, dass**
- die elektrischen Anschlüsse (11, 12) der Spule (10) mit Anschlusselementen des Schalenkerns (20), die vorzugsweise an dem Schalenkern (20) angebracht oder einstückig an dem Schalenkern (20) angeformt sind, verbunden werden und
- die Anschlusselemente des Schalenkerns (20) mit der Auswertschaltung der Sensoreinrichtung elektrisch verbunden werden.

4. Verfahren nach einem der voranstehenden Ansprüche,
**dadurch gekennzeichnet, dass**
die elektrischen Anschlüsse (11, 12) der Spule (10) durch Beschichten, Verkleben und/oder durch Verzinnen mechanisch versteift werden.

5. Verfahren nach einem der voranstehenden Ansprüche,
**dadurch gekennzeichnet, dass**
- der Schalenkern (20) zumindest einen randseitigen Schlitz (22, 23) und/oder ein Durchgangsloch (26) aufweist und
- mindestens einer der elektrischen Anschlüsse (11, 12) abschnittsweise in den randseitigen Schlitz (22, 23) eingelegt oder durch das Durchgangsloch (26) hindurchgeführt wird.

6. Verfahren nach einem der voranstehenden Ansprüche,
**dadurch gekennzeichnet, dass**
- der Schalenkern (20) einen ersten randseitigen Schlitz (22) und einen zweiten randseitigen Schlitz (23) aufweist,
- ein Abschnitt eines der elektrischen Anschlüsse (11) der Spule (10) in den ersten randseitigen Schlitz (22) eingelegt wird und durch diesen außen an dem Schalenkern (20) vorbeigeführt wird und
- ein Abschnitt des anderen elektrischen Anschlusses (12) der Spule (10) in den zweiten randseitigen Schlitz (23) eingelegt wird und durch diesen außen an dem Schalenkern (20) vorbeigeführt wird.

7. Verfahren nach einem der voranstehenden Ansprüche,
**dadurch gekennzeichnet, dass**
die selbsttragende, spulenkörperfreie Spule (10) hergestellt wird, indem während und/oder nach dem Wickeln der Spule (10) die Wicklungen untereinander verklebt werden.

8. Verfahren nach einem der voranstehenden Ansprüche,
**dadurch gekennzeichnet, dass**
- die selbsttragende, spulenkörperfreie Spule (10) durch Wickeln eines Drahts, der eine temperaturfeste Grundisolation und eine bei Erhitzen selbst verklebende Deckschicht aufweist, hergestellt wird und
- während und/oder nach dem Wickeln der Spule (10) die Spule (10) erhitzt und/oder mit einem Lösungsmittel behandelt wird und dadurch die Wicklungen der Spule (10) untereinander mit dem Material der Deckschicht verklebt werden.

9. Verfahren nach einem der voranstehenden Ansprüche,
**dadurch gekennzeichnet, dass**
die selbsttragende, spulenkörperfreie Spule (10) aus einem Backlackdraht hergestellt wird.

10. Verfahren nach einem der voranstehenden Ansprüche,
**dadurch gekennzeichnet, dass**
die selbsttragende, spulenkörperfreie Spule (10) zwischenkörperfrei in die umlaufende Nut (21) des Schalenkerns (20) eingesetzt wird.

## Claims

1. Method for producing an inductive sensor apparatus, wherein, in the method, a coil (10) is inserted into a pot-type core (20), wherein the coil (10) inserted into a circumferential groove (21) of the pot-type core (20) is a self-supporting coil (10) without a coil body, wherein:
- the pot-type core (20) has a depression or a through-hole (26),
- the electrical connections (11, 12) of the coil (10) are electrically connected directly to an evaluation circuit of the sensor apparatus, **characterized in that**:
- a projection of a printed circuit board, with the evaluation circuit of the sensor apparatus, is introduced into the depression or the through-hole of the pot-type core,
- the electrical connections of the coil are soldered directly to connection surfaces (32, 33) on the printed circuit board (30) of the evaluation circuit by virtue of the electrical connections (11, 12) already prepositioned on the electrical connection surfaces (32, 33) being soldered on after the printed circuit board (30) has been introduced,
- wherein connection ends (11a, 12a) of the electrical connections (11, 12) are mechanically stiffened before or after the coil (10) has been inserted into the pot-type core (20), and flexurally stiff connections (11, 12) are formed, specifically before the connection ends (11a, 12a) are soldered onto the printed circuit board (30), in order to simplify the subsequent soldering of the connection ends onto the printed circuit board (30).

2. Method according to Claim 1,
**characterized in that**
the electrical connections (11, 12) are each stiffened from the winding region (13) of the coil (10) up to the associated connection ends (11a, 12a).

3. Method according to either of the preceding claims,
**characterized in that**
- the electrical connections (11, 12) of the coil (10) are connected to connection elements of the pot-type core (20) that are preferably attached to the pot-type core (20) or integrally formed on the pot-type core (20), and
- the connection elements of the pot-type core (20) are electrically connected to the evaluation circuit of the sensor apparatus.

4. Method according to one of the preceding claims,
**characterized in that**
the electrical connections (11, 12) of the coil (10) are mechanically stiffened by means of coating, adhesive bonding and/or tin plating.

5. Method according to one of the preceding claims,
**characterized in that**
- the pot-type core (20) has at least one edge-side slot (22, 23) and/or a through-hole (26), and
- at least one of the electrical connections (11, 12) is partially inserted into the edge-side slot (22, 23) or guided through the through-hole (26).

6. Method according to one of the preceding claims,
**characterized in that**
- the pot-type core (20) has a first edge-side slot (22) and a second edge-side slot (23),
- a portion of one of the electrical connections (11) of the coil (10) is inserted into the first edge-side slot (22) and is guided past the outside of the pot-type core (20) thereby, and
- a portion of the other electrical connection (12) of the coil (10) is inserted into the second edge-side slot (23) and is guided past the outside of the pot-type core (20) thereby.

7. Method according to one of the preceding claims,
**characterized in that**
the self-supporting coil (10) without a coil body is produced by virtue of the windings being adhesively bonded to one another during and/or after the winding of the coil (10).

8. Method according to one of the preceding claims,
**characterized in that**
- the self-supporting coil (10) without a coil body is produced by winding a wire that has a thermally resistant base insulation and a cover layer that is selfadhesive upon being heated, and
- the coil (10) is heated and/or treated with a solvent during and/or after the winding of the coil (10) and the windings of the coil (10) are adhesively bonded to one another by the material of the cover layer as a result.

9. Method according to one of the preceding claims,
**characterized in that**
the self-supporting coil (10) without a coil body is produced from a stoved-enamel wire.

10. Method according to one of the preceding claims,
**characterized in that**
the self-supporting coil (10) without a coil body is inserted into the circumferential groove (21) of the pot-type core (20) without an intermediate body.

## Revendications

1. Procédé de fabrication d'un dispositif capteur inductif, une bobine (10) étant, dans le procédé, insérée dans un noyau de coque (20), la bobine (10) étant une bobine (10) autoporteuse et sans corps de bobine qui est insérée dans une rainure circonférentielle (21) du noyau de coque (20),
- le noyau de coque (20) comportant un creux ou un trou traversant (26),
- les connexions électriques (11, 12) de la bobine (10) étant reliées électriquement directement à un circuit d'évaluation du dispositif capteur, **caractérisé en ce que** :
- une saillie d'une carte de circuit imprimé pourvue du circuit d'évaluation du dispositif capteur est insérée dans l'évidement ou le trou traversant du noyau de coque,
- les connexions électriques de la bobine sont soudées directement aux surfaces de connexion (32, 33) sur la carte de circuit imprimé (30) du circuit d'évaluation par soudage, après l'insertion de la carte de circuit imprimé (30), des connexions électriques (11, 12) qui ont déjà été pré-positionnées sur les surfaces de connexion électrique (32, 33),
- les extrémités (11a, 12a) des connexions électriques (11, 12) étant renforcées mécaniquement avant ou après l'insertion de la bobine (10) dans le noyau de coque (20) et des connexions rigides (11, 12) étant formées, à savoir avant de souder les extrémités de connexion (11a, 12a) sur la carte de circuit imprimé (30) afin de simplifier le soudage ultérieur des extrémités de connexion sur la carte de circuit imprimé (30) .

2. Procédé selon la revendication 1,
**caractérisé en ce que**
les connexions électriques (11, 12) sont renforcées à chaque fois depuis la zone d'enroulement (13) de la bobine (10) jusqu'aux extrémités de connexion associées (11a, 12a).

3. Procédé selon l'une des revendications précédentes,
**caractérisé en ce que**
- les connexions électriques (11, 12) de la bobine (10) sont reliées à des éléments de connexion du noyau de coque (20), qui sont de préférence fixés au noyau de coque (20) ou formés d'une seule pièce sur le noyau de coque (20), et
- les éléments de connexion du noyau de coque (20) sont reliés électriquement au circuit d'évaluation du dispositif capteur.

4. Procédé selon l'une des revendications précédentes,
**caractérisé en ce que**
les connexions électriques (11, 12) de la bobine (10) sont renforcées mécaniquement par revêtement, collage et/ou étamage.

5. Procédé selon l'une des revendications précédentes,
**caractérisé en ce que**
- le noyau de coque (20) comporte au moins une fente côté bord (22, 23) et/ou un trou traversant (26) et
- au moins une des connexions électriques (11, 12) est insérée par portions dans la fente côté bord (22, 23) ou passée à travers le trou traversant (26).

6. Procédé selon l'une des revendications précédentes,
**caractérisé en ce que**
- le noyau de coque (20) comporte une première fente côté bord (22) et une deuxième fente côté bord (23),
- une portion d'une des connexions électriques (11) de la bobine (10) est insérée dans la première fente côté bord (22) et est guidée à travers celle-ci extérieurement devant le noyau de coque (20) et
- une portion de l'autre connexion électrique (12) de la bobine (10) est insérée dans la deuxième fente côté bord (23) et est guidée à travers celle-ci extérieurement devant le noyau de coque (20).

7. Procédé selon l'une des revendications précédentes,
**caractérisé en ce que**
la bobine (10) autoporteuse et sans corps de bobine est fabriquée par collage des enroulements les uns aux autres pendant et/ou après l'enroulement de la bobine (10) .

8. Procédé selon l'une des revendications précédentes,
**caractérisé en ce que**
- la bobine (10) autoporteuse et sans corps de bobine est fabriquée par enroulement d'un fil qui comporte une isolation de base résistante à la température et une couche de recouvrement auto-adhésive lorsqu'elle est chauffée, et
- pendant et/ou après l'enroulement de la bobine (10), la bobine (10) est chauffée et/ou traitée avec un solvant et ainsi les enroulements de la bobine (10) sont collés les uns aux autres avec la matière de la couche de recouvrement.

9. Procédé selon l'une des revendications précédentes,
**caractérisé en ce que**
la bobine (10) autoporteuse et sans corps de bobine est fabriquée à partir d'un fil d'émail cuit.

10. Procédé selon l'une des revendications précédentes,
**caractérisé en ce que**
la bobine (10) autoporteuse et sans corps de bobine est insérée dans la rainure circonférentielle (21) du noyau de coque (20) sans aucun corps intermédiaire.
